# EUROPEAN PATENT SPECIFICATION

(11) **EP 2 503 858 B1**
(45) Date of publication and mention of the grant of the patent: **25.12.2013**
(21) Application number: 11305329.2
(22) Date of filing: 24.03.2011
(51) Int. Cl.: H05K 1/02, H01P 1/213, H03H 7/46

(54) **Diplexer circuit and method of manufacturing a printed circuit board therefor**
Diplexerschaltung und Herstellungsverfahren für eine Leiterplatte dafür
Circuit diplexeur et procédé de fabrication d'une carte de circuit imprimé correspondante

(43) Date of publication of application: 26.09.2012
(73) Proprietor: Alcatel Lucent, 75007 Paris (FR)
(72) Inventor: Pivit, Florian, 15 Dublin (IE)
(74) Representative: Wetzel, Emmanuelle

(56) References cited:
- WO-A1-2005/104149
- DE-B3- 10 300 956
- US-A1- 2003 186 674
- US-A1- 2005 104 685
- US-A1- 2007 127 725
- US-A1- 2007 217 175

## Description

The present invention relates to printed circuit boards for forming a diplexer circuit, more particularly but not exclusively to a diplexer circuit for a base station transceiver of a mobile communication system.

### Background

Modem base station transceivers need to be operated at high efficiency levels to provide users of a mobile communication system with high data rate and quality services while keeping the power consumption and radiated power at a possible minimum. Therefore, power amplifiers (PA for abbreviation) and low noise amplifiers (LNA for abbreviation), building the high-frequency (HF for abbreviation) -front-end of a base station, should experience as low noise and interference as possible. One possible source of noise and interference is a potential connection or crosstalk of the transmitter branch with the PA and the receiver branch with the LNA through a commonly used antenna, i.e. parts of the transmit signal may occur in the reception branch. Therefore, respective filter circuits can be utilized to attenuate such crosstalk.

One example of such a filter circuit is a so-called diplexer, which is a passive device that implements frequency domain multiplexing. Communication systems may us time division duplex (TDD for abbreviation) or frequency division duplex (FDD for abbreviation). In TDD, transmission and reception are separated in the time domain, i.e. for a given time either transmission or reception is carried out at the base station transceiver. In FDD, transmission and reception are separated in the frequency domain, i.e. different frequency bands are used for transmission and reception. Diplexers can be based on two band-pass filters, separating the transmission band from the reception band in an FDD system. Two ports (e.g., L and H, as abbreviations for low and high frequency band) are multiplexed onto a third port (e.g., S as abbreviation for signal), which connects an antenna or antenna system. The signals on ports L and H occupy disjoint frequency bands. Theoretically, the signals on L and H can coexist on port S without interfering with each other.

Typically, the signal on port L may occupy a single low frequency band and the signal on port H may occupy a higher frequency band. In that situation, the diplexer can consist of a low-pass filter connecting ports L and S and a high-pass filter connecting ports H and S.

Ideally, all the signal power on port L is transferred to the S port and vice versa, and all the signal power on port H is transferred to port S and vice versa. Ideally, the separation of the signals is complete, i.e. none of the low band signal is transferred from the S port to the H port. In the real world, some power will be lost, and some signal power will leak to the wrong port.

The isolation between the transmit-frequency band and the receive-frequency band in a FDD radio system is a very essential performance requirement for a base station transceiver. Due to the very high sensitivity of the receiver and the relatively much larger output power, the isolation, which is usually required between these two bands may be in the order of 70, 80, 90 or even 100dB.

Document US 2005/104685 A1 discloses a high-frequency module with a structure wherein transmitting filters, receiving filters and high-frequency power amplifiers are mounted on a multilayered substrate and wherein matching circuits are inserted between input terminals of the receiving filters and output terminals of the transmitting filters. Transmission lines as components of the matching circuits, and the like are formed internally of the multilayered substrate. Thus, the whole body of the high-frequency module can be downsized.

Document US2007/127725 provides a concept for a radio module. On the side of a first main surface of a module base, a transmitter is provided which includes wiring patterns formed on the first main surface and electronic components provided on the wiring patterns. On the side of a second main surface of the module base, a receiver is provided which includes wiring patterns formed on the second main surface and electronic components provided on the wiring patterns. A motherboard has an opening formed therein, and an electronic circuit module is mounted on the motherboard, with the receiver inserted into the opening.

A cable television diplexer and telephony module that can be employed in CATV data transmission systems to enhance performance levels and reduce manufacturing costs is disclosed in document US2003/0186674 A1. The cable television diplexer and telephony module includes a printed circuit board substrate, and a diplexer having a low pass filter section and a high pass filter section, each of which has components mounted on the substrate. The respective low pass and high pass filter sections of the diplexer include one or more high Q value planar spiral inductors. Each spiral inductor includes a narrow track of metal disposed on the substrate and wound around a center to form a circular spiral curve having a plurality of turns. The spiral inductor may be fabricated on the substrate of the cable television diplexer and telephony module, or on a separate substrate, using a standard PCB fabrication process.

An RF electronic component for mounting on a substrate is provided by document US2007/217175 A1. The component includes a housing and at least one electronic device having an input and/or output incorporated in the housing. At least one input/output terminal connects to a connection pad on the substrate and an electrical transition provides an electrical connection between the input/output terminal and an input/output of an electronic device incorporated in the electronic component. The electrical transition comprises a side termination at least partially located on an outer surface of the housing and an array of conductive through holes formed inside the housing at an offset from the side termination. The array is arranged so that the axes of the through holes are substantially mutually parallel and coplanar, and the array of through holes is connected to form a ground plane at the offset from the side termination.

Document DE 103 00 956 B3 relates to contacting technology for signal connections in the substrate of an extremely high frequency module, in particular a microwave or millimeter wave module. The extremely high frequency module contains a) a multilayer substrate having at least two dielectric layers and metallization layers and inter-layer connections, and b) chips positioned on the top of the multilayer substrate. The chips are electrically connected to each other and to the structures in the metallization layers by means of HF connections. The HF connection is realized by means of at least two conductor lines, which exhibit fanning. The concept allows for simple contacting of chips having small intervals between the external contacts on the multilayer substrate. WO 2005/104149 represents further pertinent prior art.

### Summary

The invention is defined by the appended claims.

Embodiments can be based on the finding that such degrees of isolation are very hard to achieve and the physical arrangement of such filters may determine very much the performance of the filter-architecture and therewith of an HF-front-end. Especially in active antenna array systems, this is important, since the required level of integration of the devices is high, which means that the TX-filter and RX-filter are placed very close together, which again causes coupling between the devices, reducing the isolation.

Embodiments provide a method for manufacturing a printed circuit board (PCB for abbreviation) configured for forming a diplexer circuit comprising a first connector for connecting a first filter and a second connector for connecting a second filter, wherein the first connector and the second connector are located on opposite sides of the printed circuit board. Such an embodiment may enable to arrange two filters on opposite sides of the PCB. It is a further finding that the isolation or the attenuation from one side of a PCB to the other may enable high integration level and high isolation levels at the same time. In other words, when placing the two filter circuits on opposite sides of the PCB they can be close together and well isolated from each other at the same time, so crosstalk may be suppressed to a high degree.

The term "connector" is to be understood as an interconnect or means for mounting electronic devices, i.e. the first or the second filter. Such a connector may be implemented as a solder-patch, which can provide mechanical support and electrical support for a filter. The connectors may enable mounting of the filters on the front side and the back side of the PCB, where the PCB is between the connectors. In embodiments solder-patches may be used to mount the filters and connect the housing of a filter to a certain voltage or reference potential. For example, the housing of a filter can be soldered to a solder patch and connected to ground potential at the same time. Embodiments may also comprise a method for manufacturing a PCB with mounting a first connector on a first side and mounting a second connector on a second side of the PCB. The connectors may be connected among each other through the PCB or to a buried ground plane within the PCB. Moreover, embodiments may comprise a method for manufacturing a diplexer circuit; such method may comprise a step of mounting a first filter on the first connector and mounting a second filter on the second connector of the PCB. These steps may comprise electrically connecting the first filter and the second filter with each other, with a buried ground plane and/or with a reference or ground potential.

In the method, the printed circuit board is therefore adapted for forming a diplexer of a base station transceiver, wherein the first filter corresponds to a transmission signal filter and the second filter corresponds to a reception signal filter. The first connector may correspond to a first solder-patch and the second connector may correspond to a second solder patch. In other words, the two solder-patches may enable mechanical and electrical connection of the filters to the PCB, achieving a mechanically stable and electrically well isolated implementation of both filters in close vicinity.

The printed circuit board comprises two layers of a non-conductive substrate and a conductive layer between the two non-conductive substrate layers.

The printed circuit board further comprises another conductive layer separated from the conductive layer by an isolating layer. The conductive layer, the other conductive layer and the isolating layer can be between the two non-conductive substrate layers. In other words, there may be two conductive parallel layers in the substrate, which may be isolated from each other, in some embodiments there may be substrate between them as well. Thus, there can actually be five layers, first substrate, first conductive layer, second substrate, second conductive layer, and third substrate. The conductive layer and the other conductive layer, i.e. the first and the second conductive layer, may be parallel and forming a wave guide structure. The wave guide structure may guide electromagnetic waves, fringing fields, or leaking currents away from the two filter structures and therewith enable a higher attenuation between the two filter structures.

The wave guide structure is adapted to a quarter of the wavelength of a center frequency based on a transmission band determined by the first filter and a reception band determined by the second filter. In other words, there is a certain bandwidth the transmission signals may have, located around a center frequency. The wave guide structure may be geometrically adapted to a certain wavelength for which the attenuation should be raised or for which the crosstalk should be suppressed. This wavelength could correspond to the center frequency of the transmission band, the center frequency of the reception band or any other frequency in between. Basically the geometry of such a structure can be adapted to the strongest interference or crosstalk in embodiments, where the wavelength of the strongest interference may depend on the filter structures, their transfer function characteristics, etc. Embodiments may therefore be based on the finding that a conductive structure within a PCB can be geometrically adapted to a crosstalk between filter structures located on opposite sides of the PCB to suppress said crosstalk.

The conductive layer and the other conductive layer, i.e. the first and the second conductive layer, form a projection around the connector for the first filter and around the connector of the second filter. The conductive layer and the other conductive layer are connected through a further connector or a via underneath the first and second connectors, wherein the projection may extend at least a quarter of the wavelength from the further connector or via. The printed circuit board may further comprise isolating means for isolating a side of the first connector from a side of the second connector to achieve attenuations for transmission band signals of more than 70, 80, 90 or 100dB.

Embodiments also provide a diplexer circuit comprising an circuit board, a first filter connected to the first connector for filtering a transmit signal in a transmission band, and a second filter connected to the second connector for filtering a receive signal in a reception band. The first and the second filter can be further connected to an antenna using a first feed-line and a second feed-line, wherein the first feed-line and the second feed-line can be located in parallel to the printed circuit board, or the first and the second filter are connected to the antenna using a common antenna port, wherein the printed circuit board comprises a feed connector or via for connecting the first and the second filter to the common antenna board.

### Brief description of the Figures

Some other features or aspects will be described using the following non-limiting embodiments of printed circuit boards and diplexer circuits by way of example only, and with reference to the accompanying figures, in which
Figure 1a shows an embodiment of a printed circuit board;
Figure 1b shows two diplexer circuits, one with separate and one with a common antenna port;
Figure 1c shows a connector of an embodiment;
Figure 1d shows another connector of an embodiment;
Figure 1e shows a diplexer circuit according to the invention, using a printed circuit board with a wave guide structure;
Figure 2a shows an embodiment of a diplexer circuit;
Figure 2b shows another embodiment of a diplexer circuit;
Figure 3a shows a diplexer circuit in a single housing; and
Figure 3b shows a diplexer circuit in separate housings.

### Description of some Embodiments

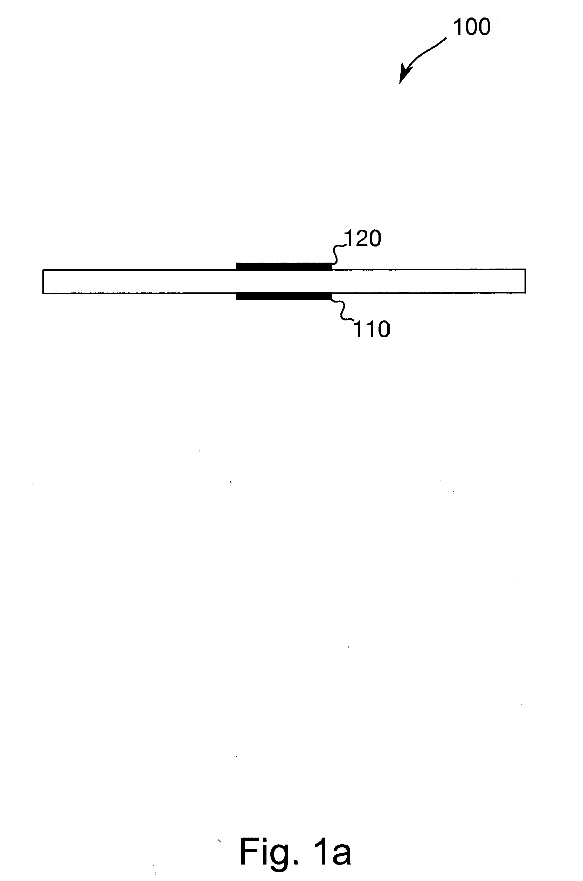

The illustrative description of the embodiments will be given in details combined with the appended figures. Figure 1a shows an embodiment of a printed circuit board 100 for forming a diplexer circuit comprising a first connector 110 for connecting a first filter and second connector 120 for connecting a second filter, wherein the first connector 110 and the second connector 120 are located on opposite sides of the printed circuit board 100. The connectors 110, 120 may enable mechanical mounting and electrical connecting of the filters on the front side and the back side of the PCB. Moreover, embodiments may provide a method for manufacturing a printed circuit board 100 for forming a diplexer circuit. The method may comprise a step of implementing the first connector 110 for connecting a first filter on a first side of the printed circuit board 100 and a step of implementing a second connector 120 for connecting a second filter 122 on a second side of the printed circuit board 100. The first connector 110 and the second connector 120 are located on opposite sides of the printed circuit board 100. In other words, the first connector 110 may be located on a front side and the second connector 120 may be located on the back side of the PCB 100.

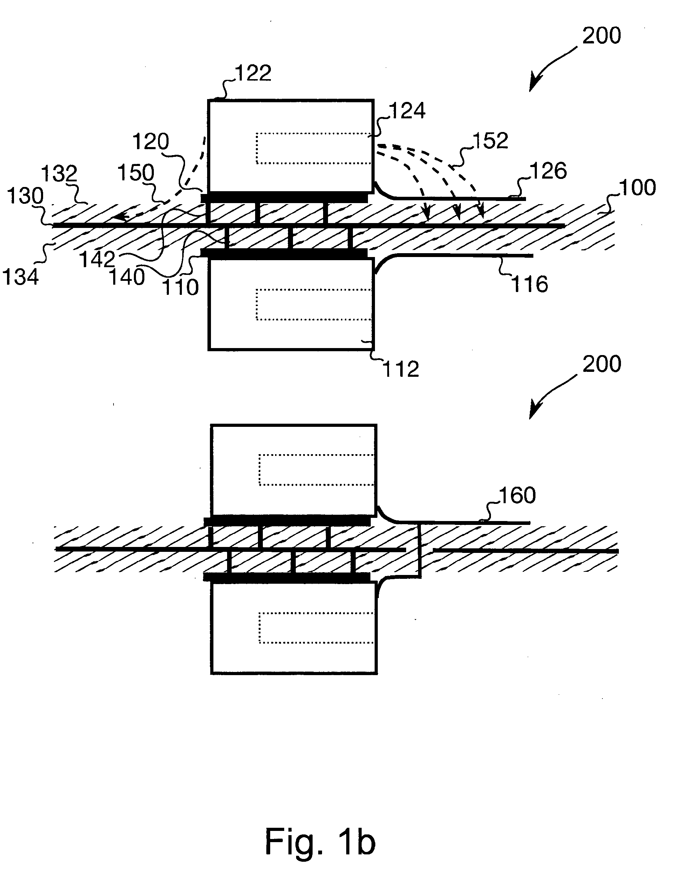

Figure 1b shows two embodiments of diplexer circuits 200, each using an embodiment of a printed circuit board 100, one with separate antenna ports or feed-lines 116, 126, and one with a common antenna port 160. The embodiment at the top of Figure 1b will be described first, the embodiment at the bottom of Figure 1b has similar components except for the feed-line or antenna ports. The description of similar components of the embodiment at the bottom will be omitted.

The embodiment at the top of Figure 1b shows the printed circuit board 100 with the two connectors 110 and 120. The embodiment further shows the mounted first filter 112 and the mounted second filter 122. The broken-line structure 124 in the second filter 122 indicates a resonator structure, which is also assumed to be present in the first filter 110. The printed circuit board 100 can be adapted for forming a diplexer of a base station transceiver, wherein the first filter 112 may correspond to a transmission signal filter or block filter and the second filter 122 may correspond to a reception signal filter or block filter. The first filter 112 and the second filter 122 may be soldered on the PCB 100. Thus, the first connector 110 may correspond to a first solder-patch and the second connector 120 may correspond to a second solder patch.

As shown in the embodiment, the printed circuit board 100 comprises two layers 132, 134 of a non-conductive substrate and a conductive layer 130 between the two non-conductive substrate layers 132, 134. The conductive layer may comprise a metal, for example, it may comprise copper or aluminum. To the two non-conductive layers 132, 134 may also be referred to as first non-conductive layer 132 and second non-conductive layer 134. The PCB 100 may comprise at least one connection or via 140 between the first connector 110 and the conductive layer 130. The PCB 100 may comprise at least one connection or via 142 between the second connector 120 and the conductive layer 130. In the embodiment shown in Figure 1b multiple such connections are shown, of which only connection 140 and 142 are referenced. Furthermore, the conductive layer 130 may have a connector for grounding the conductive layer 130.

In Figure 1b the arrow 150 indicates coupling currents which are isolated by the conductive layer 130, which may serve as a ground plane. The vias 140, 142 may ensure contact between the ground plane 130 and the solder-patches 110 and 120. Moreover, the arrows 152 indicate fringing fields, which are also isolated by the ground plane 130. The figure at the bottom of Figure 1b shows a similar embodiment but with a common antenna port 160 instead of separate feed-lines 116 and 126 as indicated in the embodiment shown at the top. In other words, embodiments may provide a diplexer circuit 200, wherein the first and the second filter 112, 122 are further connected to an antenna using a first feed-line 116 and a second feed-line 126, wherein the first feed-line 116 and the second feed-line 126 are located or run in parallel to the printed circuit board 100. In other embodiments the first and the second filter 112, 122 can be connected to the antenna using a common antenna port 160 and the printed circuit board 100 can comprise a feed connector or via for connecting the first and the second filter 112, 122 to the common antenna port 160. Figure 1b illustrates an embodiment wherein filters 112,122 are placed on opposite sides of PCB 100, increasing the decoupling by a ground plane 130 and with the possibility to form a common (antenna) port (cf. embodiment at the bottom).

Furthermore, embodiments may provide a diplexer circuit 200, wherein the printed circuit board 100 comprises two non-conductive substrate layers 132, 134 and at least one conductive layer 130 between the two non-conductive substrate layers 132, 134, wherein the conductive layer 130 is adapted for providing an attenuation between the transmission signal and the reception signal, which is higher than 70, 80, 90 or 100dB.

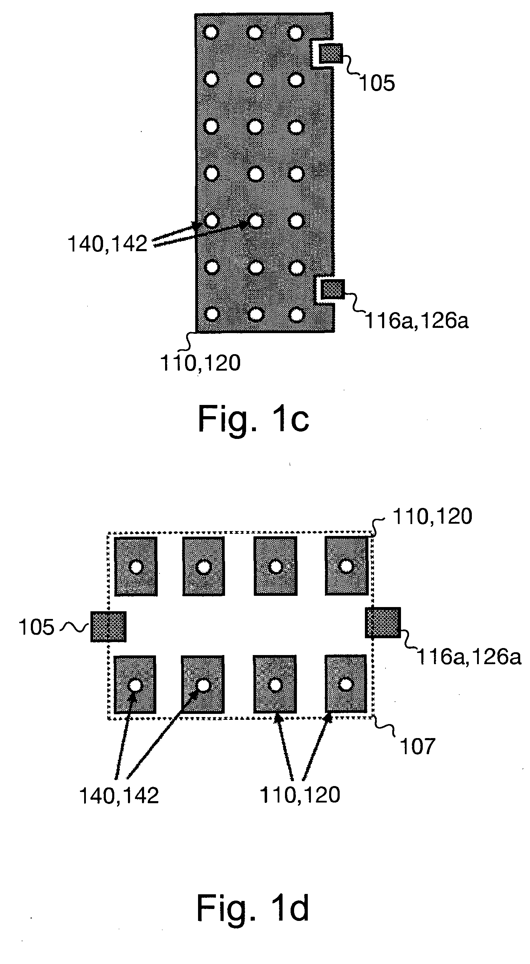

Figure 1c shows an exemplified connector 110, 120 of an embodiment of a printed circuit board. The connector 110, 120 may correspond to a connector for a ceramic block filter, as is indicated by the plane structure footprint in Figure 1c. In embodiments the connectors 110, 120 may correspond to means for mounting the filters 112, 122. On the one hand, the connectors 110, 120 may serve as means for mechanically stabilizing the filters 112, 122 on the PCB and on the other hand they may electrically connect the filters 112, 122 to the PCB. In some embodiments the connectors 110, 120 may connect the housing of the filters 112, 122 to the conductive layer 130 using the vias 140, 142. Figure 1c shows a plane connector or soldering patch 110, 120, which comprises multiple vias or connections to an underlying conductive layer, where in Figure 1b only two connections or vias 140, 142 are referenced. The underlying conductive layer may correspond to a buried ground layer. The white dots within the connector 110, 120 indicate that there can be a plurality of connections to the underlying conductive layer in embodiments. Furthermore, Figure 1c shows a connector or solder-patch 116a, 126a which can be used to connect a filter 112, 122 to the feed-lines 116, 126 or to the antenna path as described above. The connector 105 in Figure 1c may serve to connect to an input or output port of a filter 112, 122, i.e. the TX-port of a transmission filter 110 or the RX-port of a reception filter 120.

Figure 1d shows another connector 110, 120 of an embodiment of a PCB. Figure 1d shows similar components as the connector 110, 120 described in Figure 1c, but multiple connectors are shown. While Figure 1c illustrates a plane connector 110, 120, Figure 1d shows a connector field or patch field being comprised of multiple connectors 110, 120.

The structure of connectors 110, 120 may correspond to a connector for an SAW (as abbreviation for surface-acoustic-wave) filter, as is indicated by the patch-field structure footprint in Figure 1d. The outline of the filter 112, 122 is indicated by the broken line 107 in Figure 1d. It can be seen that the filter 112, 122 may be connected to multiple connectors 110, 120, of which at least some may have a via or connection 140, 142 to the conductive layer 130, which may correspond to a buried ground layer. Figure 1d also shows the port-connector or solder-patch105 and the antenna path connector or solder-patch 116a, 126a as has already been detailed above.

Embodiments may also provide a method for manufacturing a PCB 100 with mounting a first connector 110 on a first side and mounting a second connector 120 on a second side of the PCB 100. The connectors 110, 120 may be connected among each other through the PCB 100 or to a buried ground plane 130 within the PCB 100. Moreover, embodiments may provide a method for manufacturing a diplexer circuit 200; such method may comprise a step of mounting a first filter 112 on the first connector 110 and mounting a second filter 122 on the second connector 120 of the PCB 100. These steps may comprise electrically connecting the first filter 112 and the second filter 122 with each other, with a buried ground plane 130 and/or with a reference or ground potential.

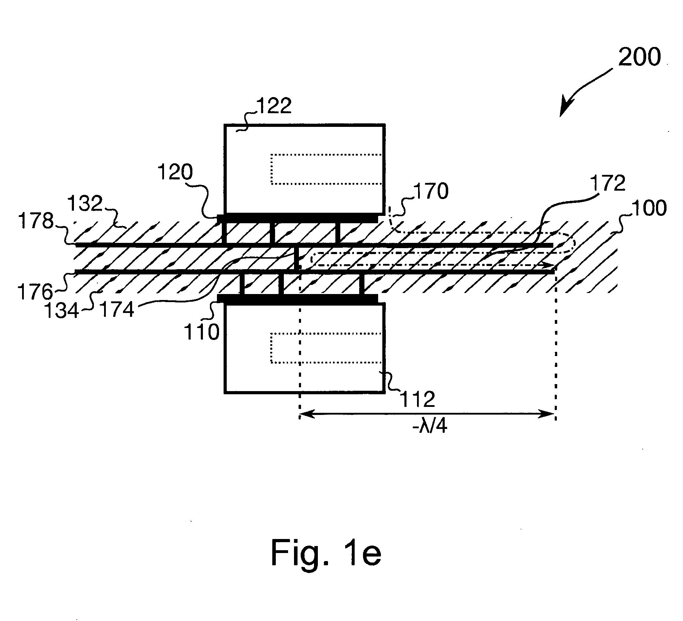

Figure 1e shows a diplexer circuit 200 using a printed circuit board 100 with a wave guide structure representing an embodiment of the invention. In the embodiment the printed circuit board 100 further comprises another conductive layer 178 separated from the conductive layer 176 by an isolating layer 172, the conductive layer 176, the other conductive layer 178 and the isolating layer 172 being between the two non-conductive substrate layers 132,134. The conductive layer 176 may also be referred to as the first conductive layer 176, the other conductive layer 178 may also be referred to as the second conductive layer 178. The conductive layer 176 and the other conductive layer 178 can be parallel and they can form a wave guide structure. The wave guide structure can be adapted to a quarter of the wavelength of a center frequency based on a transmission band determined by the first filter 112 and a reception band determined by the second filter 122.

The conductive layer 176 and the other conductive layer 178 form a projection or shielding around the connector 110 for the first filter 112 and the connector 120 of the second filter 122, wherein the conductive layer 176 and the other conductive layer 178 are connected through a further connector 174 or a via 174 underneath the first and second connectors 110,120, wherein the projection or shielding extends at least a quarter of the wavelength from the further connector or via 174. The projection or shielding may be formed by the two conductive layers 176, 178 being mounted within the PCB with a gap in between, wherein the gap may extend to a quarter of the wavelength.

The extent of the projection or wave guide structure is also indicated in Figure 1e by the distance of *λ*/4 between the dotted lines. Figure 1e illustrates an embodiment, which provides an improved ground plane with a leakage-current-suppressing ground-plane structure.

Generally, in embodiments the printed circuit board 100 may comprise means for guiding an electromagnetic wave, the means for guiding the wave can be adapted for guiding the electromagnetic wave for at least a quarter of a wavelength of the wave. Such means may for example correspond to the above-described geometrical structure of the conductive layers in a PCB. In embodiments, the PCB 100 can further comprise isolating means for isolating a side of the first connector 110 from a side of second connector 120 to achieve attenuation for transmission band signals of more than 70, 80, 90 or 100dB. The isolating means may correspond to the conductive layer described for the above embodiments.

The diplexer circuit 200 of the invention comprises further a first filter 112 connected to the first connector 110 for filtering a transmit signal in a transmission band, and a second filter 122 connected to the second connector 120 for filtering a receive signal in a reception band.

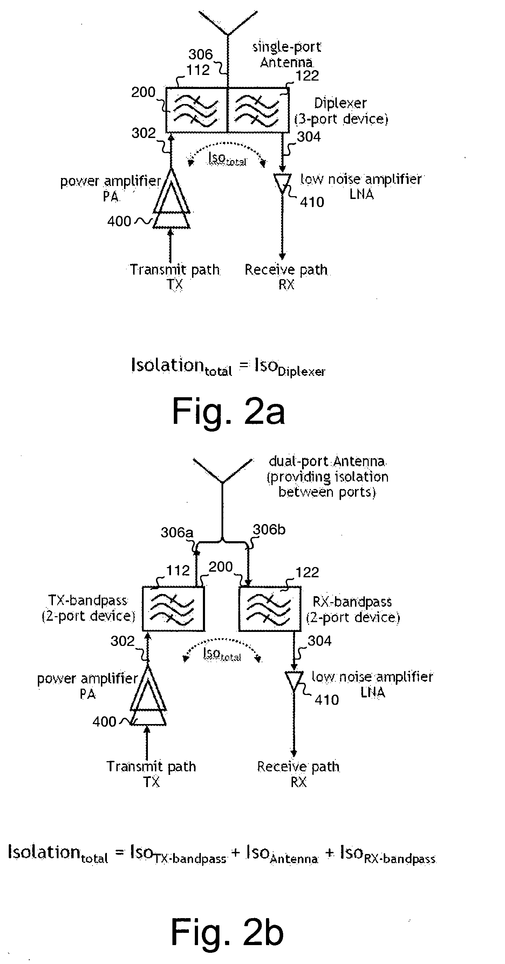

In Figure 2a an architecture or diplexer-configuration for an implementation of an FDD-radio is shown. Figure 2a shows a diplexer circuit 200, with a transmit path, in which a PA 400 is located, followed by a PA-port 302 of the diplexer 200, which connects to the antenna using antenna port 306. In the receive path, from the antenna the diplexer circuit 200 connects to an LNA 410 through LNA-port 304. The isolation between the PA-port 302 and the LNA-port 304 is achieved only by the filters 112, 122 in the diplexer circuit 200. Here, the two filters 112, 122 are molded into one single physical entity and the coupling between the PA-port 302 and the LNA-port 304 is therefore not so much influenced by the mounting of the filters 112, 122. In embodiments, such a structure, i.e. a structure wherein the two filters 112, 122 are implemented in a single housing, may also comprise the above described PCB 100, where the PCB 100 can be adapted accordingly, i.e. adapted to fit with the housing. The PCB 100 may also provide means for mounting of further components.

Figure 2b shows another embodiment of a diplexer circuit 200, which shows similar components as the embodiment in Figure 2a, however, the two filters 112,122 are in separate physical entities and the embodiment therefore utilizes two antenna ports 306a and 306b according to a band-pass-filter-configuration with a 2-port-antenna. In the diplexer 200 shown in Figure 2b, isolation between the ports 302, 304 may be further increased by the isolation between the two antenna-ports 306a and 306b. This isolation can be achieved e.g. by two orthogonal polarizations, e.g. in a dual-polarized dipole or patch antenna. Especially in this configuration, it may be essential how the two filters 112, 122 are located within the physical implementation of the radio, since the two filters 112, 122 are two separate entities. Generally, the more closely they are arranged, the larger the coupling between the devices by leakage-currents and fringing fields becomes. This can be decreased by placing them apart, which again contradicts the requirements for high physical integration. Therefore, embodiments may provide an advantage of being able to place the two filters 112, 122 closely, achieving a high level of integration, while at the same time achieving a high level of isolation through the PCB 100 separating the filters and, in some embodiments, having further integrated isolating or shielding means.

In embodiments, the size and weight of the filters 112, 122 may be adapted to enable mounting them on opposite sides of the circuit board 100. For example, filters which are small enough to be used as surface mounted devices like ceramic block filters (CB for abbreviation), SAW or film-bulk-acoustic-resonator-filters (FBAR for abbreviation) can be used. For embodiments, ceramic block filters can be used, but embodiments shall not be limited to ceramic filter technology, other filter technologies can also be applied.

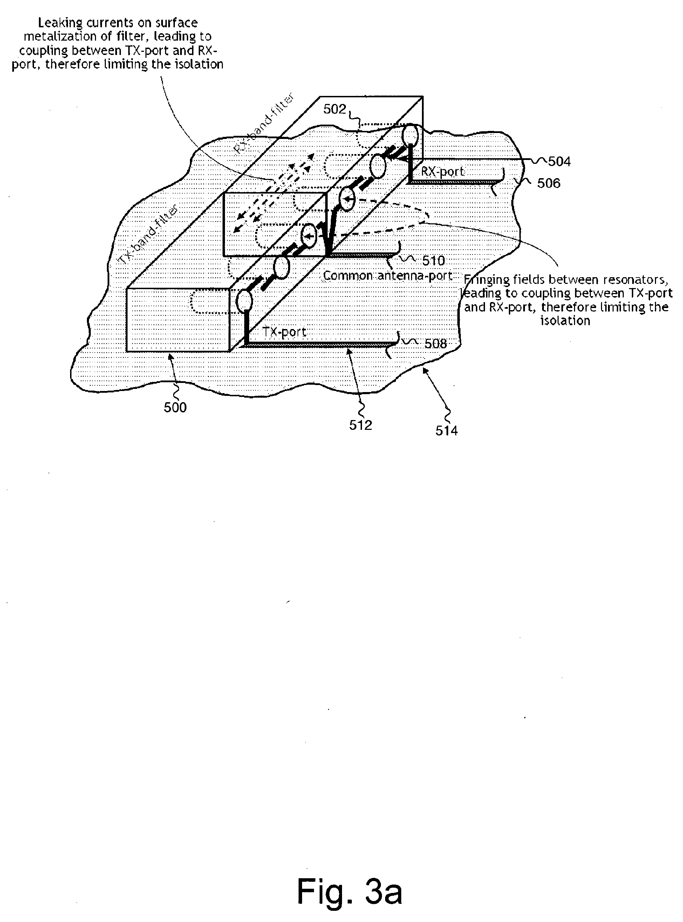

Figure 3a shows a diplexer circuit in a single housing 500 implemented as block-filter, e.g. as a ceramic block-filter. Figure 3a illustrates a surface mounted block diplexer, in which TX- and RX-filter form one single physical entity, limiting isolation by fringing fields and leakage currents, used in a radio-architecture as shown in Figure 2a. The diplexer comprises a receive-band filter (RX-band-filter) at the top and a transmit-band-filter (TX-band-filter) at the bottom. The diplexer comprises resonator structures 502 and coupling structures 504. Furthermore, Figure 3a shows three ports, a receive port 506, a transmit port 508 and a common antenna port 510. Moreover, several signal lines 512 and a PCB 514 are indicated in Figure 3a. A broken line arrow on the right hand side indicates fringing fields between the resonators, which lead to coupling between the TX-port 508 and the RX-port 506 and which therefore limit the isolation. On the left hand side of Figure 3a, the broken line arrows indicate leaking currents on the surface metallization of the filter, which lead to coupling between the TX-port 508 and the RX-port 506 and which also limit the isolation.

Such filter devices usually are available as two separate performing devices, except they are built in a diplexer-function within one single entity, see Figure 3a. A diplexer implemented as one single entity, e.g. using the conventional approach, may have the disadvantage that leaking currents flow on the same surface, therefore the isolation is hard to achieve once it goes beyond a certain level (approximately more than 60dB). This may usually not be enough in terms of isolation performance.

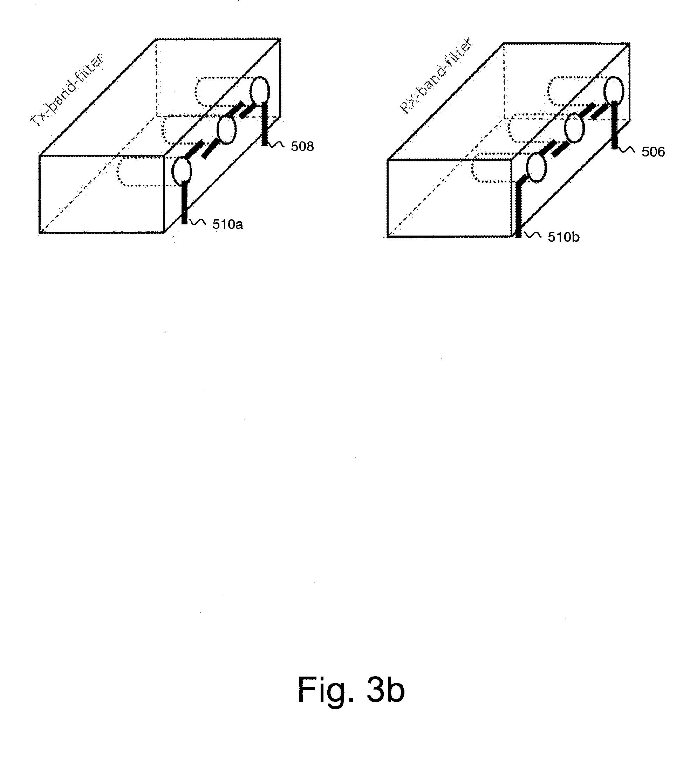

Figure 3b shows a diplexer circuit in separate housings, where the transmit-band-filter is shown on the left and the receive-band-filter is shown on the right. Figure 3b illustrates two surface mounted block filters, in which TX- and RX-filter form two separate physical entities, increasing isolation by fringing fields and leakage currents, but limiting the use to radio-architectures as shown in Figure 2b. Figure 3b shows similar components as Figure 3a, i.e. the two filters comprise resonator and coupling structures. As the diplexer uses separate housings there also are separate antenna ports 510a and 510b. If the TX-band-filter and RX-band-filter are built as two entities, they still have to be placed next to each other to form a diplexer function, see Figure 3b, again leading to coupling by fringing fields and currents running on the common ground-plane. These disadvantages may be overcome in embodiments, by separating the two filters 112, 122 by the PCB 100, i.e. by mounting the two filters 112, 122 on opposite sides of the PCB 100.

If the filters are placed on the same side of the circuit board and maybe even on the same solder patch, then the fringing fields have to be suppressed by complicated measures like encapsulating walls, which are expensive and defeat the purpose of highly integrated circuits. In embodiments the filters can be placed on opposite sides of the circuit board. This may enable the introduction of an isolating ground plane in a multi-layer-PCB, which can act as an isolating plane, shielding the two filters from each other. Embodiments may therefore allow constructing highly integrated radio structures while maintaining a high isolation between the two filters despite their close vicinity. Embodiments may overcome disadvantages resulting from e.g. encapsulating boxes, which are expensive and increase the mechanical- and circuit-layout-effort.

The description and drawings merely illustrate the principles of the invention. It will thus be appreciated that those skilled in the art will be able to devise various arrangements that, although not explicitly described or shown herein, embody the principles of the invention and are included within its scope as defined in the claims. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. It should be appreciated by those skilled in the art that any block diagrams herein represent conceptual views of illustrative circuitry embodying the principles of the invention.

## Claims

1. A method for manufacturing a printed circuit board (100) configured for forming a diplexer circuit comprising
forming a wave guide structure in the printed circuit board comprising two layers (132;134) of a non-conductive substrate and two isolated conductive layers (176; 178) between the two non-conductive substrate layers (132;134), the two isolated conductive layers (176; 178) being separated by an isolating layer (172), wherein the two isolated conductive layers (176; 178) are parallel and wherein the wave guide structure is adapted to a quarter of the wavelength of a center frequency based on a radio transmission band which is determined by a first filter (112) and a radio reception band which is determined by a second filter (122), the wave guide structure is adapted for guiding the electromagnetic wave for at least a quarter of a wavelength of the wave;
implementing a first connector (110) for electrically connecting the first filter (112) on a first side of the printed circuit board (100); and
implementing a second connector (120) for electrically connecting the second filter (122) on a second side of the printed circuit board (100), wherein the first connector (110) and the second connector (120) are located on opposite sides of the printed circuit board (100); the wave guide structure being located between the first and second connectors (110; 120), wherein the conductive layer (176) and the other conductive layer (178) form a projection or shielding around the first connector (110) and the second connector (120), wherein the conductive layer (176) and the other conductive layer (178) are connected through a further connector (174) or a via (174) underneath the first and second connectors (110;120), wherein the projection or shielding extends at least a quarter of said wavelength of a center frequency from the further connector or via (174).

2. A diplexer circuit (200) comprising : a printed circuit board (100) for forming the diplexer circuit comprising a first connector (110) for connecting a first filter (112) and second connector (120) for connecting a second filter (122), wherein the first connector (110) and the second connector (120) are located on opposite sides of the printed circuit board (100), wherein the printed circuit board further comprises two layers (132;134) of a non-conductive substrate and two isolated conductive layers (176; 178) between the two non-conductive substrate layers (132;134), the two isolated conductive layers (176; 178) being separated by an isolating layer (172), wherein the two isolated conductive layers (176; 178) are parallel and forming a wave guide structure, which is adapted to a quarter of the wavelength of a center frequency based on a transmission band determined by the first filter (112) and a reception band determined by the second filter (122);
a first filter (112) electrically connected to the first connector (110) for filtering a transmit signal in a transmission band, and a second filter (122) electrically connected to the second connector (120) for filtering a receive signal in a reception band, the wave guide structure being located between the first and second filter (112; 122), wherein the conductive layer (176) and the other conductive layer (178) form a projection or shielding around the first connector (110) and the second connector (120), wherein the conductive layer (176) and the other conductive layer (178) are connected through a further connector (174) or a via (174) underneath the first and second connectors (110;120), wherein the projection or shielding extends at least a quarter of said wavelength of a center frequency from the further connector or via (174).

3. The diplexer circuit (200) of claim 2, wherein the first and the second filter (112;122) are further connected to an antenna using a first feed-line (116) and a second feed-line (126), wherein the first feed-line (116) and the second feed-line (126) are located in parallel to the printed circuit board (100), or wherein the first and the second filter (112;122) are connected to the antenna using a common antenna port (160) and wherein the printed circuit board (100) comprises a feed connector or via for connecting the first and the second filter (112;122) to the common antenna port (160).

4. A method for manufacturing a diplexer circuit according to claim 2, comprising manufacturing a printed circuit board (100) for forming the diplexer circuit comprising
forming a wave guide structure in the printed circuit board comprising two layers (132;134) of a non-conductive substrate and two isolated conductive layers (176; 178) between the two non-conductive substrate layers (132;134), the two isolated conductive layers (176; 178) being separated by an isolating layer (172), wherein the two isolated conductive layers (176; 178) are parallel and wherein the wave guide structure is adapted to a quarter of the wavelength of a center frequency based on a transmission band determined by the first filter (112) and a reception band determined by the second filter (122);
implementing a first connector (110) for connecting a first filter (112) on a first side of the printed circuit board (100); and
implementing a second connector (120) for connecting a second filter (122) on a second side of the printed circuit board (100), wherein the first connector (110) and the second connector (120) are located on opposite sides of the printed circuit board (100);
mounting a first filter (112) on the first connector (110); and
mounting a second filter (122) on the second connector (120) of the printed circuit board (100).

## Patentansprüche

1. Verfahren zur Herstellung einer Leiterplatte (100), welche als Diplexerschaltung konfiguriert ist, umfassend:
Bilden einer Wellenleiterstruktur in der Leiterplatte, mit zwei Schichten (132; 134) aus einem nicht leitfähigem Substrat und zwei isolierten leitfähigen Schichten (176; 178) zwischen den zwei nicht leitfähigen Substratschichten (132; 134), wobei die zwei isolierten leitfähigen Schichten (176; 178) durch eine Isolierschicht (172) voneinander getrennt sind, wobei die zwei isolierten leitfähigen Schichten (176; 178) parallel zueinander angeordnet sind, und wobei die Wellenleiterstruktur auf ein Viertel der Wellenlänge einer Mittenfrequenz basierend auf einem Funkübertragungsband, welches durch einen ersten Filter (112) bestimmt wird, und einem Funkempfangsband, welches durch einen zweiten Filter (122) bestimmt wird, ausgelegt ist, wobei die Wellenleiterstruktur zum Führen der elektromagnetischen Welle auf mindestens einem Viertel einer Wellenlänge der Welle ausgelegt ist;
Implementierten eines ersten Verbinders (110) für den elektrischen Anschluss des ersten Filters (112) auf einer ersten Seite der Leiterplatte (100); und
Implementieren eines zweiten Verbinders (120) für den elektrischen Anschluss des zweiten Filters (122) auf einer zweiten Seite der Leiterplatte (100), wobei der erste Verbinder (110) und der zweite Verbinder (120) auf sich gegenüberliegenden Seiten der Leiterplatte (100) angeordnet sind; wobei die Wellenleiterstruktur zwischen dem ersten und dem zweiten Verbinder (110; 120) angeordnet ist, wobei die leitfähige Schicht (176) und die andere leitfähige Schicht (178) einen Vorsprung oder eine Abschirmung um den ersten Verbinder (110) und den zweiten Verbinder (120) herum bilden, wobei die leitfähige Schicht (176) und die andere leitfähige Schicht (178) über einen weiteren Verbinder (174) oder eine Durchkontaktierung (174) unterhalb des ersten und des zweiten Verbinders (110; 120) miteinander verbunden sind; wobei sich der Vorsprung oder die Abschirmung mindestens über ein Viertel der besagten Wellenlänger einer Mittenfrequenz ab dem weiteren Verbinder oder der Durchkontaktierung (174) erstreckt.

2. Diplexerschaltung (200), umfassend:
Eine Leiterplatte (100), welche die Diplexerschaltung bildet, mit einem ersten Verbinder (110) für den Anschluss eines ersten Filters (112), und einem zweiten Verbinder (120) für den Anschluss eines zweiten Filters (122), wobei der erste Verbinder (110) und der zweite Verbinder (120) auf sich gegenüberliegenden Seiten der Leiterplatte (100) angeordnet sind, wobei die Leiterplatte weiterhin zwei Schichten (132; 134) aus einem nicht leitfähigem Substrat und zwei isolierte leitfähige Schichten (176; 178) zwischen den zwei nicht leitfähigen Substratschichten (132; 134) umfasst, wobei die zwei isolierten leitfähigen Schichten (176; 178) durch eine Isolierschicht (172) voneinander getrennt sind,
wobei die zwei isolierten leitfähigen Schichten (176; 178) parallel zueinander angeordnet sind und eine Wellenleiterstruktur bilden, welche auf ein Viertel der Wellenlänge einer Mittenfrequenz basierend auf einem Übertragungsband,
welches durch den ersten Filter (112) bestimmt wird, und einem Empfangsband,
welches durch den zweiten Filter (122) bestimmt wird, ausgelegt ist;
einen ersten Filter (112), welcher elektrisch an den ersten Verbinder (110) angeschlossen ist, um ein Sendesignal in einem Übertragungsband zu filtern, und
einen zweiten Filter (122), welcher elektrisch an den zweiten Verbinder (120) angeschlossen ist, um ein Empfangssignal in einem Empfangsband zu filtern,
wobei die Wellenleiterstruktur zwischen dem ersten und dem zweiten Filter (112; 122) angeordnet ist, wobei die leitfähige Schicht (176) und die andere leitfähige Schicht (178) einen Vorsprung oder eine Abschirmung um den ersten Verbinder (110) und den zweiten Verbinder (120) herum bilden, wobei die leitfähige Schicht (176) und die andere leitfähige Schicht (178) über einen weiteren Verbinder (174) oder eine Durchkontaktierung (174) unterhalb des ersten und des zweiten Verbinders (110; 120) miteinander verbunden sind; wobei sich die der Vorsprung oder die Abschirmung mindestens über ein Viertel der besagten Wellenlänge einer Mittenfrequenz ab dem weiteren Verbinder oder der Durchkontaktierung (174) erstreckt.

3. Diplexerschaltung (200) nach Anspruch 2, wobei der erste und der zweite Filter (112; 122) weiterhin unter Verwendung einer ersten Speiseleitung (116) und einer zweiten Speiseleitung (126) an eine Antenne angeschlossen sind, wobei die erste Speiseleitung (116) und die zweite Speiseleitung (126) parallel zur Leiterplatte (100) angeordnet sind, oder wobei der erste und der zweite Filter (112; 122) unter Verwendung eines gemeinsamen Antennenports (160) an die Antenne angeschlossen sind, und wobei die Leiterplatte (100) einen Speiseverbinder oder eine Durchkontaktierung für den Anschluss des ersten und des zweiten Filters (112; 122) an den gemeinsamen Antennenport (160) umfasst.

4. Verfahren zum Herstellern einer Diplexschaltung gemäß Anspruch 2, umfassend:
Herstellern einer Leiterplatte (100), welche die Diplexerschaltung bildet, umfassend:
Bilden einer Wellenleiterstruktur in der Leiterplatte, mit zwei Schichten (132; 134) aus einem nicht leitfähigen Substrat und zwei isolierten leitfähigen Schichten (176; 178) zwischen den zwei nicht leitfähigen Substratschichten (132; 134), wobei die zwei isolierten leitfähigen Schichten (176; 178) durch eine Isolierschicht (172) voneinander getrennt sind, wobei die zwei isolierten leitfähigen Schichten (176; 178) parallel zueinander angeordnet sind, und wobei die Wellenleiterstruktur auf ein Viertel der Wellenlänge einer Mittenfrequenz basierend auf einem Übertragungsband, welches durch den ersten Filter (112) bestimmt wird, und einem Empfangsband, welches durch den zweiten Filter (122) bestimmt wird, ausgelegt ist;
Implementieren eines ersten Verbinders (110) für den Anschluss eines ersten Filters (112) auf einer ersten Seite der Leiterplatte (100); und
Implementieren eines zweiten Verbinders (120) für den Anschluss eines zweiten Filters (122) auf einer zweiten Seite der Leiterplatte (100), wobei der erste Verbinder (110) und der zweite Verbinder (120) auf sich gegenüberliegenden Seiten der Leiterplatte (100) angeordnet sind;
Montieren eines ersten Filters (112) auf dem ersten Verbinder (110); und Montieren eines zweiten Filters (122) auf dem zweiten Verbinder (120) der Leiterplatte (100).

## Revendications

1. Procédé de fabrication d'une carte de circuit imprimé (100) configurée pour former un circuit diplexeur comprenant les étapes suivantes
former une structure de guide d'ondes dans la carte de circuit imprimé comprenant deux couches (132 ; 134) d'un substrat non conducteur et deux couches conductrices isolées (176; 178) entre les deux couches de substrat non conducteur (132; 134), les deux couches conductrices isolées (176; 178) étant séparées par une couche isolante (172), dans lequel les deux couches conductrices isolées (176 ; 178) sont paralléles et dans lequel la structure de guide d'ondes est adaptée à un quart de la longueur d'onde d'une fréquence centrale sur la base d'une bande d'émission radio qui est déterminée par un premier filtre (112) et d'une bande de réception radio qui est déterminée par un deuxième filtre (122), la structure de guide d'ondes est adaptée pour guider l'onde électromagnétique pour au moins un quart d'une longueur d'onde de l'onde ;
mettre en oeuvre un premier connecteur (110) pour connecter électriquement le premier filtre (112) sur un premier côté de la carte de circuit imprimé (100) ; et
mettre en oeuvre un deuxième connecteur (120) pour connecter électriquement le deuxième filtre (122) sur un deuxième côté de la carte de circuit imprimé (100), dans lequel le premier connecteur (110) et le deuxième connecteur (120) sont situés sur des côtés opposés de la carte de circuit imprimé (100) ; la structure de guide d'ondes étant située entre le premier et le deuxième connecteurs (110; 120), dans lequel la couche conductrice (176) et l'autre couche conductrice (178) forment une partie saillante ou une protection autour du premier connecteur (110) et du deuxième connecteur (120), dans lequel la couche conductrice (176) et l'autre couche conductrice (178) sont connectées par l'intermédiaire d'un autre connecteur (174) ou d'un trou d'interconnexion (174) sous le premier et le deuxième connecteurs (110; 120), dans lequel la partie saillante ou la protection s'étend sur au moins un quart de ladite longueur d'onde d'une fréquence centrale à partir de l'autre connecteur ou du trou d'interconnexion (174).

2. Circuit diplexeur (200) comprenant : une carte de circuit imprimé (100) pour former le circuit diplexeur comprenant un premier connecteur (110) pour connecter un premier filtre (112) et un deuxième connecteur (120) pour connecter un deuxième filtre (122), dans lequel le premier connecteur (110) et le deuxième connecteur (120) sont situés sur des côtés opposés de la carte de circuit imprimé (100), dans lequel la carte de circuit imprimé comprend en outre deux couches (132 ; 134) d'un substrat non conducteur et deux couches conductrices isolées (176 ; 178) entre les deux couches de substrat non conducteur (132 ; 134), les deux couches conductrices isolées (176 ; 178) étant séparées par une couche isolante (172), dans lequel les deux couches conductrices isolées (176 ; 178) sont parallèles et forment une structure de guide d'ondes, qui est adaptée à un quart de la longueur d'onde d'une fréquence centrale sur la base d'une bande d'émission déterminée par le premier filtre (112) et d'une bande de réception déterminée par le deuxième filtre (122) ;
un premier filtre (112) connecté électriquement au premier connecteur (110) pour filtrer un signal d'émission dans une bande d'émission, et un deuxième filtre (122) connecté électriquement au deuxième connecteur (120) pour filtrer un signal de réception dans une bande de réception, la structure de guide d'ondes étant située entre le premier filtre et le deuxième filtre (112 ; 122), dans lequel la couche conductrice (176) et l'autre couche conductrice (178) forment une partie saillante ou une protection autour du premier connecteur (110) et du deuxième connecteur (120), dans lequel la couche conductrice (176) et l'autre couche conductrice (178) sont connectées par l'intermédiaire d'un autre connecteur (174) ou d'un trou d'interconnexion (174) sous le premier et le deuxième connecteurs (110 ; 120), dans lequel la partie saillante ou la protection s'étend sur au moins un quart de ladite longueur d'onde d'une fréquence centrale à partir de l'autre connecteur ou du trou d'interconnexion (174).

3. Circuit diplexeur (200) selon la revendication 2, dans lequel le premier et le deuxième filtres (112; 122) sont en outre connectés à une antenne en utilisant une première ligne d'alimentation (116) et une deuxième ligne d'alimentation (126), dans lequel la première ligne d'alimentation (116) et la deuxième ligne d'alimentation (126) sont situées parallèlement à la carte de circuit imprimé (100), ou dans lequel le premier filtre et le deuxième filtre (112 ; 122) sont connectés à l'antenne en utilisant un port d'antenne commun (160) et dans lequel la carte de circuit imprimé (100) comprend un connecteur d'alimentation ou un trou d'interconnexion pour connecter le premier filtre et le deuxième filtre (112 ; 122) au port d'antenne commun (160).

4. Procédé de fabrication d'un circuit diplexeur selon la revendication 2, comprenant
la fabrication d'une carte de circuit imprimé (100) pour former le circuit diplexeur comprenant les étapes suivantes
former une structure de guide d'ondes dans la carte de circuit imprimé comprenant deux couches (132 ; 134) d'un substrat non conducteur et deux couches conductrices isolées (176 ; 178) entre les deux couches de substrat non conducteur (132 ; 134), les deux couches conductrices isolées (176 ; 178) étant séparées par une couche isolante (172), dans lequel les deux couches conductrices isolées (176 ; 178) sont parallèles et dans lequel la structure de guide d'ondes est adaptée à un quart de la longueur d'onde d'une fréquence centrale sur la base d'une bande d'émission déterminée par le premier filtre (112) et d'une bande de réception déterminée par le deuxième filtre (122) ;
mettre en oeuvre un premier connecteur (110) pour connecter un premier filtre (112) sur un premier côté de la carte de circuit imprimé (100) ; et
mettre en oeuvre un deuxième connecteur (110) pour connecter un deuxième filtre (112) sur un deuxième côté de la carte de circuit imprimé (100), dans lequel le premier connecteur (110) et le deuxième connecteur (120) sont situés sur des côtés opposés de la carte de circuit imprimé (100) ;
le montage d'un premier filtre (112) sur le premier connecteur (110) ; et
le montage d'un deuxième filtre (122) sur le deuxième connecteur (120) de la carte de circuit imprimé (100).
